# DEMANDE DE BREVET EUROPEEN

(11) **EP 4 826 724 A1**
(43) Date de publication de la demande: **21.10.2026**
(21) Numéro de dépôt: 26169364.2
(22) Date de dépôt: 31.03.2026
(51) Int. Cl.: G11C 13/00, H10B 63/00, H10B 63/10, H10N 70/00, H10N 70/20

(54) **CELLULE MEMOIRE A CHANGEMENT DE PHASE COMPORTANT DES ELEMENTS RESISTIFS MONTES EN PARALLELE**

(30) Priorité: 14.04.2025 FR 2503944
(71) Demandeur: STMicroelectronics International N.V., 1228 Plan-les-Ouates, Geneva (CH)
(72) Inventeur: BERTHELON, Remy, 38920 Crolles (FR); DESMOULINS, Simon, 38700 Corenc (FR); LE FRIEC, Yannick, 38570 Goncelin (FR)
(74) Mandataire: Casalonga

(57) **Abrégé**

La présente description porte sur une cellule mémoire à changement de phase, comportant au moins un premier et un deuxième éléments résistifs (H1, H2), montés électriquement en parallèle entre des contacts conducteurs (11, 24). Le premier élément résistif (H1) présente une résistance électrique (R1) ayant une première valeur (R1_{TREAD}) à une première température (T_{READ}) inférieure à la température de cristallisation (T_{c}), et une deuxième valeur (R1_{TRESET}) à une deuxième température (T_{RESET}) supérieure à la température de fusion (T_{f}), inférieure ou égale à sa première valeur (R1_{TREAD}). Le deuxième élément résistif (H2) présente une résistance électrique (R2) ayant une première valeur (R2_{TREAD}) à la première température (T_{READ}), supérieure à la première valeur (R1_{TREAD}) du premier élément résistif (H1), et une deuxième valeur (R2_{TRESET}) à la deuxième température (T_{RESET}), inférieure à la deuxième valeur (R1_{TRESET}) du premier élément résistif (H1).

## Description

### DOMAINE TECHNIQUE

La présente description concerne de façon générale les circuits intégrés comportant des cellules mémoires à changement de phase (PCM pour Phase *Change Memory* en anglais).

### CONTEXTE

Une cellule mémoire à changement de phase est un type de mémoire non volatile qui peut être vue comme un dipôle électrique à résistance variable où est stockée une information binaire. Classiquement, une telle cellule mémoire comporte une portion active formée d'un matériau à changement de phase et disposée entre deux électrodes.

Lorsque le matériau de la portion active est en phase cristalline, sa résistivité est faible et permet de coder l'état SET (habituellement, état logique 1), alors qu'en phase amorphe, sa résistivité est plus élevée et permet de coder l'état RESET (état logique 0).

Les températures nécessaires aux changements de phase sont obtenues par l'échauffement d'un élément résistif de la cellule mémoire par effet Joule. Cet élément résistif correspond à une résistance de chauffe (*heater*) qui est en contact thermique et électrique avec la portion active de la cellule mémoire.

Il existe toutefois un besoin d'améliorer les performances d'une telle cellule mémoire, et notamment dans le cadre d'une matrice de cellules mémoires identiques.

### RESUME

Selon un aspect de la présente divulgation, il est proposé une cellule mémoire à changement de phase comportant une portion active en un matériau à changement de phase présentant une température de cristallisation et une température de fusion. La cellule mémoire comporte :
∘ un premier contact conducteur ;
∘ au moins un premier et un deuxième éléments résistifs, montés électriquement en parallèle, et couplés électriquement au premier contact conducteur,
   - le premier élément résistif présentant une résistance électrique ayant : une première valeur à une première température inférieure à la température de cristallisation, et une deuxième valeur à une deuxième température supérieure à la température de fusion, inférieure ou égale à sa première valeur,
   - le deuxième élément résistif présentant une résistance électrique ayant : une première valeur à la première température, supérieure à la première valeur du premier élément résistif, et une deuxième valeur à la deuxième température, inférieure à la deuxième valeur du premier élément résistif ;
∘ la portion active, couplée aux premier et deuxième éléments résistifs ;
∘ un deuxième contact conducteur, couplé à la portion active.

Selon un mode de réalisation, les premier et deuxième éléments résistifs comportent chacun une première partie s'étendant du premier contact conducteur à la portion active, la première partie du premier élément résistif étant espacée de la première partie du deuxième élément résistif par un premier espaceur réalisé en un matériau électriquement isolant.

Selon un mode de réalisation, les premier et deuxième éléments résistifs comportent chacun une deuxième partie s'étendant à partir de la première partie et située au contact du premier contact conducteur, le premier espaceur recouvrant la deuxième partie du premier élément résistif.

Selon un mode de réalisation, la cellule mémoire comporte un deuxième espaceur s'étendant le long d'une surface de la première partie du deuxième élément résistif, opposée au premier espaceur, et recouvrant la deuxième partie du deuxième élément résistif.

Selon un mode de réalisation, les premier et deuxième éléments résistifs présentent des épaisseurs identiques ou différentes.

Selon un mode de réalisation, à la première température, la première valeur de la résistance électrique du deuxième élément résistif est au moins 2 fois supérieure à la première valeur de la résistance électrique du premier élément résistif.

Selon un mode de réalisation, le premier élément résistif et/ou le deuxième élément résistif sont réalisés en des matériaux à base de nitrure de titane silicium et/ou de tungstène.

Selon un mode de réalisation, la portion active est réalisée en un chalcogénure, de préférence en un composé ternaire de chalcogénure.

Selon un autre aspect, il est proposé un circuit intégré comportant une matrice de cellules mémoires identiques selon l'une quelconque des caractéristiques précédentes.

Selon un autre aspect, il est proposé un procédé de fabrication d'au moins une cellule mémoire selon l'une quelconque des caractéristiques précédentes, comportant les étapes suivantes :
∘ réaliser une première couche isolante et au moins un premier contact conducteur la traversant pour déboucher sur une face supérieure ;
∘ réaliser une deuxième couche isolante recouvrant la première couche isolante et le premier contact conducteur ;
∘ réaliser au moins une ouverture au travers de la deuxième couche isolante et débouchant sur le premier contact conducteur ;
∘ déposer une première couche mince conductrice sur un flanc de l'ouverture, et gravure localisée pour obtenir le premier élément résistif ;
∘ déposer une couche mince isolante sur un flanc du premier élément résistif, et gravure localisée pour obtenir un premier espaceur ;
∘ déposer une deuxième couche mince conductrice sur un flanc du premier espaceur, et gravure localisée pour obtenir le deuxième élément résistif ;
∘ réalisation de la portion active ;
∘ réalisation du deuxième contact conducteur.

Selon un mode de réalisation, la première couche mince conductrice est déposée par dépôt chimique en phase vapeur.

Selon un mode de réalisation, la deuxième couche mince conductrice est déposée par dépôt par couches atomiques.

Selon un mode de réalisation, la première couche mince conductrice et/ou la deuxième couche mince conductrice sont réalisées en un matériau à base d'un nitrure de titane silicium et/ou de tungstène.

Selon un mode de réalisation, le procédé de fabrication comporte, avant l'étape de réalisation de la portion active, une étape de remplissage de l'ouverture, suivie d'une étape de réalisation d'une couche continue en le matériau à changement de phase.

Selon un autre aspect, il est proposé un procédé de fabrication d'un circuit intégré comportant une matrice de cellules mémoires identiques réalisées simultanément par le procédé selon l'une quelconque des caractéristiques précédentes.

### BREVE DESCRIPTION DES FIGURES

D'autres avantages et caractéristiques de l'invention apparaîtront à l'examen de la description détaillée de modes de réalisation et de mise en oeuvre, nullement limitatifs, et des dessins annexés sur lesquels :
La Figure 1A est une vue schématique et partielle, en coupe transversale, d'un circuit intégré comportant des cellules mémoires selon un mode de réalisation ;
La Figure 1B illustre un exemple de variations en fonction de la température de la résistance électrique équivalente associée à deux éléments résistifs d'une cellule mémoire selon un mode de réalisation ;
Les Figures 2A à 2F illustrent différentes étapes d'un procédé de fabrication d'un circuit intégré comportant des cellules mémoires selon un mode de réalisation.

### DESCRIPTION DETAILLEE

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

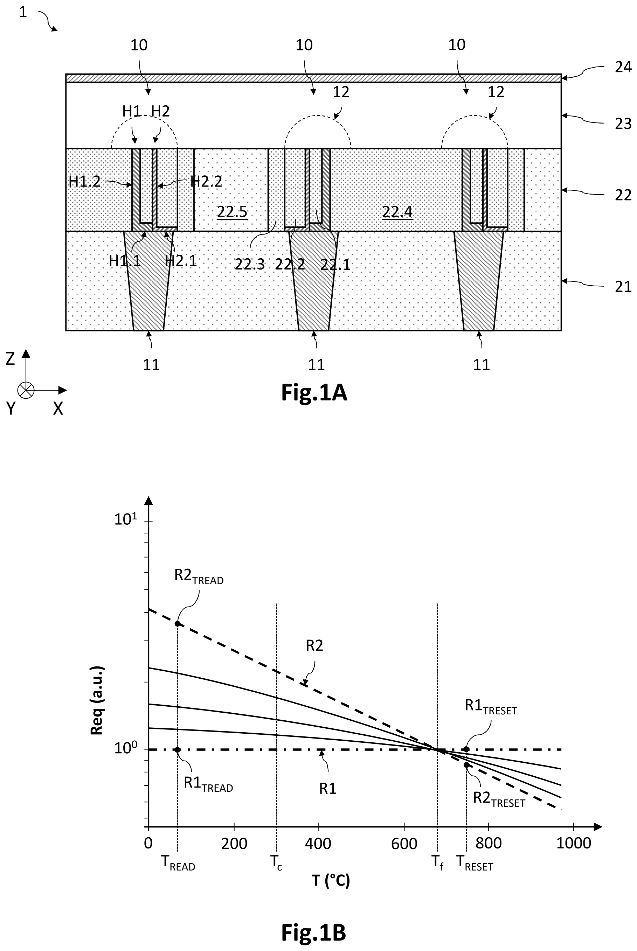

La **Figure 1A** est une vue schématique et partielle, en coupe transversale, d'un circuit intégré 1 comportant au moins une cellule mémoire 10 à changement de phase selon un mode de réalisation, et ici une matrice de cellules mémoires identiques.

On définit ici et pour la suite de la description un repère direct tridimensionnel XYZ, où le plan XY est parallèle au plan principal du circuit intégré, et où l'axe Z est orienté suivant l'épaisseur de celui-ci. Par ailleurs, les termes « inférieur » et « supérieur » s'entendent comme étant relatifs à un positionnement croissant suivant la direction +Z.

D'une manière générale, chaque cellule mémoire 10 comporte *a minima* un contact conducteur inférieur 11, au moins deux éléments résistifs H1, H2 montés électriquement en parallèle, une portion active 12 d'un matériau à changement de phase, et un contact conducteur supérieur 24.

Ainsi, les éléments résistifs H1, H2 sont couplés électriquement, d'une part, au contact conducteur inférieure 11, et d'autre part, au contact conducteur supérieur 24. Chaque élément résistif peut ainsi comporter une partie longitudinale allant d'une extrémité inférieure couplée électriquement au contact conducteur inférieure 11 à une extrémité supérieure couplée électriquement au contact conducteur supérieur 24. Les parties longitudinales des éléments résistifs H1, H2 sont alors isolées électriquement l'une de l'autre.

Rappelons qu'en fonctionnement, trois opérations peuvent être effectuées : une opération de lecture (READ) où il s'agit de déterminer la résistance électrique de la cellule mémoire 10 pour connaître l'état SET ou RESET de celle-ci ; une étape de programmation en écriture (état SET) ; et une étape de programmation en effacement (état RESET).

L'opération de lecture (READ) consiste à déterminer la résistance électrique de la cellule mémoire, par exemple en appliquant une tension électrique et en mesurant le courant électrique qui traverse la cellule mémoire. Si le courant électrique est maximal, cela correspond à une portion active dont le matériau est en phase cristalline et présente alors une faible résistance électrique : l'état de la cellule mémoire correspond habituellement à l'état SET (état logique 1). Si en revanche, le courant électrique est minimal, le matériau de la portion active est alors en phase amorphe et présente donc une forte résistance électrique : la cellule mémoire présente l'état RESET (état logique 0). Cette opération de lecture est effectuée à une température T_{READ} de la cellule mémoire qui est inférieure à la température de cristallisation T_{c} du matériau à changement de phase, et peut être à température ambiante (c'est-à-dire lors de l'utilisation du produit, généralement entre -40°C et +165°C).

L'opération de programmation en écriture (SET) correspond à la cristallisation du matériau de la portion active. Ici, la cellule mémoire peut être soumise à une impulsion électrique dont les propriétés (intensité, durée, temps de descente...) sont choisies pour porter la température de la portion active à une valeur T_{SET} au moins égale à la température de cristallisation T_{c}. Le matériau de la portion active passe alors de la phase amorphe à la phase cristalline, et la cellule mémoire présente alors l'état SET.

L'opération de programmation en effacement (RESET) correspond à l'amorphisation du matériau de la portion active. Ici, la cellule mémoire peut être soumise à une impulsion électrique dont les propriétés (intensité, durée, temps de descente...) sont choisies pour porter la température de la portion active à une valeur T_{RESET} supérieure à la température de fusion T_{f}: T_{RESET} > T_{f}. Le matériau de la portion active passe de la phase cristalline à la phase amorphe, et la cellule mémoire présente alors l'état RESET.

Revenons à la **Figure 1A****.** Dans cet exemple, le circuit intégré 1 comporte une couche isolante inférieure 21, réalisée en un matériau électriquement isolant tel qu'un oxyde de silicium. Cette couche 21 peut reposer sur une couche de passivation (non représentée), réalisée en un matériau électriquement isolant tel qu'un nitrure de silicium.

Notons que le circuit intégré 1 comporte habituellement une structure FEOL (*Front End Of Line*) sur laquelle repose la couche isolante inférieure 21 et à laquelle sont couplées électriquement les cellules mémoires 10. Cette structure FEOL comporte des éléments électroniques tels que les transistors à effet de champ, notamment pour commander les cellules mémoires. Elle n'est pas représentée par souci de clarté. Une structure BEOL (*Back End Of Line*) peut également être présente sous ou dans la couche isolante inférieure 21.

Des contacts conducteurs inférieurs 11, réalisés en au moins un matériau électriquement conducteur, de préférence métallique tel que du cuivre, du tungstène, entre autres, traversent verticalement la couche isolante inférieure 21. Dans ce mode de réalisation, chaque cellule mémoire 10 comporte un contact conducteur 11. Ces contacts conducteurs 11 présentent une forme de via traversant.

Une couche isolante intermédiaire 22, réalisée en au moins un matériau électriquement isolant tel qu'un oxyde et/ou un nitrure de silicium, recouvre la couche isolante inférieure 21, et entoure les éléments résistifs H1, H2 dans le plan XY. Elle est formée de différentes portions isolantes (espaceurs...) décrites plus loin.

Chaque cellule mémoire 10 comporte au moins deux éléments résistifs H1, H2, montés électriquement en parallèle, et couplés électriquement au même contact conducteur inférieur 11 et à la même portion active 12. Dans ce mode de réalisation, elle comporte deux éléments résistifs, mais elle pourrait comporter davantage d'éléments résistifs.

Chaque élément résistif H1, H2 forme un élément de chauffe (*heater*) configuré pour permettre la programmation d'un état logique par changement de phase du matériau de la portion active 12. Il est donc réalisé en un matériau électriquement conducteur, et présente une résistance électrique R dont la valeur dépend de la température de la cellule mémoire 10 en fonctionnement.

La résistance électrique R d'un élément résistif s'exprime, d'une manière générale, en fonction de la résistivité ρ de son matériau, et de ses dimensions L, l, e, par la relation suivante : R = ρ×L/(e×l), où L est sa hauteur, l sa largeur et e son épaisseur.

Selon un mode de réalisation, chaque élément résistif H1, H2 présente une architecture dite « wall », et comporte au moins une partie verticale H1.2, H2.2 de hauteur L suivant l'axe Z, d'épaisseur e suivant ici l'axe X, et de largeur l suivant ici l'axe Y. La hauteur L et la largeur l de chaque élément résistif H1, H2 peuvent être identiques. Les épaisseurs e1 et e2 peuvent être identiques ou différentes, comme expliqué plus loin.

Chaque élément résistif H1, H2 peut également comporter une partie inférieure H1.1, H2.1, s'étendant à partir d'une extrémité inférieure de la partie verticale H1.2, H2.2 dans le plan XY au contact du contact conducteur inférieur 11. La partie verticale H1.1, H2.1 et la partie inférieure H1.2, H2.2 sont agencées ici en forme de L. D'autres agencements sont envisageables.

La résistance électrique R1 du premier élément résistif H1 présente notamment : une première valeur R1_{TREAD} à une première température inférieure à la température de cristallisation T_{c}, telle que la température de lecture T_{READ} ; et une deuxième valeur R1_{TRESET} à une deuxième température supérieure à la température de fusion T_{f}, telle que la température T_{RESET} de programmation de l'état RESET.

De même, la résistance électrique R2 du deuxième élément résistif H2 présente notamment : une première valeur R2_{TREAD} à la première température (température de lecture T_{READ}) ; et une deuxième valeur R2_{TRESET} à la deuxième température (température T_{RESET} de programmation de l'état RESET).

Les éléments résistifs H1 et H2 présentent des matériaux en termes de résistivité et des dimensions telles que :
- à la première température (température T_{READ} de lecture), la valeur R1_{TREAD} est inférieure à la valeur R2_{TREAD} : R1_{TREAD} < R2_{TREAD}, de sorte que le courant électrique passe majoritairement par le premier élément résistif H1 ;
- à la deuxième température (température T_{RESET} de programmation RESET), la valeur R2_{TRESET} est inférieure à la valeur R1_{TRESET} : R2_{TRESET} < R1_{TRESET}, de sorte que le courant électrique passe majoritairement par le deuxième élément résistif H2.

A titre d'exemple, dans le cas d'un matériau à changement de phase de type germanium antimoine tellure (GeSbTe, appelé GST), la température de cristallisation T_{c} peut être de l'ordre de 300°C, et la température de fusion T_{f} peut être de l'ordre de 650°C. Ces valeurs dépendent notamment de la teneur en germanium et en antimoine. La température T_{READ} peut être inférieure à T_{c} de 25°C, 50°C voire davantage. Il peut s'agir de la température d'utilisation du produit, laquelle peut être comprise, par exemple, entre -40°C et +165°C environ. La température T_{RESET} peut être supérieure à T_{f} de 25°C, 50°C, voire davantage, et peut être égale à 700°C, 750°C voire 800°C dans le cas d'une température T_{f} à 650°C environ.

Le premier élément résistif H1 peut présenter une variation en température de sa résistivité ρ1 qui peut être constante entre les températures T_{READ} (par exemple 25°C) et T_{RESET} (par exemple 750°C), ou peut être légèrement décroissante, par exemple d'au plus 30%, voire 20%, voire de 10%.

A titre d'exemple, la valeur ρ1_{TREAD} de la résistivité ρ1 peut être comprise entre 0.5 à 1mΩ.cm, et la valeur ρ1_{TRESET} peut être sensiblement égale ou légèrement inférieure. Ainsi, la valeur ρ1_{TREAD} peut être égale à 1mΩ.cm environ, et la valeur ρ1_{TRESET} peut être comprise entre 0.8mΩ.cm et 1mΩ.cm, voire entre 0.9mΩ.cm et 1mΩ.cm.

Le deuxième élément résistif H2 peut présenter une variation en température de sa résistivité ρ2 qui est davantage décroissante entre les températures T_{READ} et T_{RESET}, par exemple d'une demi-décade voire d'une décade. Par ailleurs, comme indiqué précédemment, la valeur R2_{TREAD} est supérieure à R1_{TREAD}, par exemple 2, 5, voire 10 fois supérieure, alors que la valeur R2_{TRESET} est inférieure à R1 _{TRESET}.

A titre d'exemple, la valeur ρ2_{TREAD} de la résistivité ρ2 peut être comprise entre 5 à 10mΩ.cm, et la valeur ρ2_{TRESET} peut être comprise entre 0.5 et 1mΩ.cm. Ainsi, la valeur ρ2_{TREAD} peut être égale à 5mΩ.cm environ (supérieure à une valeur ρ1_{TREAD} de 1mΩ.cm), et la valeur ρ2_{TRESET} peut être égale à 0.8mΩ.cm (inférieure à une valeur p2_{TREAD} de 1mΩ.cm).

L'élément résistif H1 et/ou l'élément résistif H2 peuvent être réalisés à base d'un nitrure de titane silicium TiSiN, de tungstène, entre autres. La différence de comportement électrique en fonction de la température peut provenir de la composition chimique du matériau, de ses propriétés structurelles (par exemple taux de porosité), entre autres.

Ainsi, l'élément résistif H1 peut être un TiSiN réalisé par dépôt chimique en phase vapeur (CVD pour *Chemical Vapor Deposition*)*.* A titre d'exemple, le dépôt CVD peut être effectué entre 390°C et 420°C environ, à une pression de 5 Torr environ, et comme précurseur du tétrakis(diméthylamido)titane (TDMAT). L'évolution de la résistivité en fonction de la température peut être ajustée en modulant la densification du matériau, notamment via la puissance utilisée lors du dépôt CVD.

Par ailleurs, l'élément résistif H2 peut être un TiSiN réalisé par dépôt par couches atomiques (ALD pour *Atomic Layer Deposition*)*.* A titre d'exemple, le dépôt ALD peut être effectué entre 400°C et 450°C environ, à une pression de 30 Torr environ. L'évolution de la résistivité en fonction de la température peut être ajustée en modulant un débit de silane SiH4 utilisé après chaque cycle de dépôt.

La **Figure 1B** illustre un exemple d'évolutions en température de la résistance électrique équivalente Req associée aux deux éléments résistifs H1, H2 montés en parallèle, d'une cellule mémoire 10 similaire à celle de la **Figure 1A****.**

Dans cet exemple, on considère que la portion active est réalisée en un matériau GST dont la température de cristallisation T_{c} est égale à 300°C environ et la température de fusion T_{f} est égale à 650°C environ. La température T_{READ} est ici la température ambiante de 25°C, et la température T_{RESET} est égale à 750°C environ.

De plus, on compare les évolutions en température de la résistance électrique Req dans le cas où l'on fait varier la proportion d'épaisseur dans l'un et l'autre des éléments résistifs. Autrement dit, on considère une épaisseur totale emax = e1 + e2, et l'on fait varier la proportion de chaque épaisseur dans l'épaisseur totale dans les cas suivants : (e1 ; e2) = (100% ;0%) ; (75% ; 25%) ; (50% ; 50%) ; (25% ; 75%) ; et (0% ; 100%).

Dans le cas (e1 ; e2) = (100% ;0%), la résistance électrique Req correspond à R1 de l'élément résistif H1, qui varie entre une valeur R1_{TREAD} et une valeur R1_{TRESET} sensiblement égale à R1_{TREAD}. L'élément résistif H1 présente une épaisseur e1 égale à emax.

Dans le cas opposé (e1 ; e2) = (0% ; 100%), la résistance électrique Req correspond à la résistance R2 de l'élément résistif H2, qui varie entre une valeur R2_{TREAD} et une valeur R2_{TRESET} très inférieure à R2_{TREAD}. L'élément résistif H2 présente une épaisseur e2 égale à emax.

A une température inférieure à T_{c} telle que la température T_{READ}, la résistance électrique R1_{TREAD} est inférieure à R2_{TREAD}, alors qu'à une température supérieure à T_{f} telle que la température T_{RESET}, c'est la résistance électrique R2_{TRESET} qui est inférieure à R1_{TRESET}.

Dans les cas où (e1 ; e2) = (75% ; 25%), (50% ; 50%), et (25% ; 75%), la résistance électrique Req varie en température entre les deux courbes R1 et R2. Le choix de la répartition d'épaisseur entre e1 et e2 permet de moduler notamment la répartition du courant électrique qui passe par chaque élément résistif H1, H2 lors d'une opération de lecture, de programmation en écriture et de programmation en effacement.

Quoi qu'il en soit, lors de l'opération de lecture, donc à la température T_{READ}, le courant électrique passe majoritairement par l'élément résistif H1 (c'est-à-dire que plus de 50% du courant électrique passe par H1), alors que lors de l'opération de programmation en effacement, donc à la température T_{RESET}, le courant électrique passe majoritairement par l'élément résistif H2 (c'est-à-dire que plus de 50% du courant électrique passe par H2).

Revenons à nouveau à la **Figure 1A****.** Chaque élément résistif H1, H2 s'étend au travers de la couche isolante intermédiaire 22 sur une hauteur L. La partie verticale H1.2, H2.2 peut s'étendre de manière parallèle à l'axe vertical Z, comme illustré ici, ou peut s'étendre de manière inclinée, comme illustré dans le document EP 3 890 024 A1.

Selon un mode de réalisation, les parties inférieures H1.1, H2.1 des éléments résistifs H1, H2 d'une même cellule mémoire 10 peuvent être au contact l'un de l'autre. Elles sont au contact électrique du même contact conducteur 11. En revanche, les parties verticales H1.2, H2.2 ne sont pas au contact l'une de l'autre, et sont espacées l'une de l'autre par un premier espaceur 22.1. Les premiers espaceurs 22.1 sont des portions de la couche isolante intermédiaire 22 qui s'étendent verticalement suivant l'axe Z et sont situées entre les parties verticales H1.2, H2.2 des éléments résistifs H1, H2 d'une même cellule mémoire 10. Ils recouvrent les parties inférieures H1.1 des éléments résistifs H1. Ils peuvent être réalisés en un nitrure de silicium.

Dans ce mode de réalisation, la couche isolante intermédiaire 22 comporte d'autres portions qui forment des deuxièmes espaceurs 22.2. Ils s'étendent verticalement suivant l'axe Z et sont situés contre les parties verticales H2.2 des éléments résistifs H2, de manière opposée aux premiers espaceurs 22.1. Ils recouvrent les parties inférieures H2.1 des éléments résistifs H2. Ils peuvent être réalisés en un nitrure de silicium.

La couche isolante intermédiaire 22 peut comporter des troisièmes espaceurs 22.3, qui s'étendent verticalement suivant l'axe Z et sont situés contre un flanc des deuxièmes espaceurs 22.2 opposé aux éléments résistifs H2. Ils peuvent être réalisés en un nitrure de silicium.

Elle comporte une portion intercalaire 22.4 située entre chaque élément résistif H1, qui peut être réalisée par exemple en un nitrure de silicium. Elle peut également comporter une portion intercalaire 22.5 située entre chaque élément résistif H2, et ici entre les troisièmes espaceurs 22.3 qui se font face dans le plan XY. Elle peut être réalisée par exemple en un oxyde de silicium.

Chaque cellule mémoire 10 comporte une portion active 12, réalisée en un matériau à changement de phase. La portion active 12 est couplée électriquement et thermiquement aux deux éléments résistifs H1, H2. Le matériau à changement de phase peut être un chalcogénure, par exemple un composé ternaire de chalcogénure, tel qu'un germanium-antimoine-tellure (GST), entre autres. Comme mentionné précédemment, la teneur en germanium et en antimoine est choisie pour obtenir les valeurs souhaitées des températures de cristallisation T_{c} et de fusion T_{f}, lesquelles peuvent être respectivement égales à 300°C environ et à 650°C environ.

Dans ce mode de réalisation, les portions actives 12 sont des zones en forme de dôme d'une même couche continue 23 en le matériau à changement de phase, qui s'étendent sur et au contact de la couche isolante intermédiaire 22 et des éléments résistifs H1, H2.

Enfin, chaque cellule mémoire 10 comporte un contact conducteur supérieur, réalisé en un matériau électriquement conducteur. Ces contacts peuvent être ici des zones d'une même couche conductrice 24 qui recouvre continûment la couche continue 23 à changement de phase. La couche conductrice 24 peut être réalisée en un ou plusieurs matériaux métalliques tels que du tungstène, du TiN, entre autres.

Notons que les cellules mémoires 10 sont généralement agencées en matrice de lignes et colonnes, de sorte que chaque cellule mémoire se trouve à l'intersection d'une ligne (ligne de bit, ou bitline) et d'une colonne (ligne de mot, wordline). Elles peuvent être commandées par des transistors de sélection, de type MOS ou bipolaire.

Bien entendu, d'autres architectures de cellules mémoires sont possibles, tant en ce qui concerne les contacts conducteurs, la forme des éléments résistifs, que celle des portions actives.

La cellule mémoire 10, et ici la matrice de cellules mémoires du circuit intégré 1, présentent ainsi des performances améliorées, tant lors de l'opération de lecture que lors de l'opération de programmation RESET.

En effet, le fait que la cellule mémoire 10 comporte deux éléments résistifs H1, H2 (voire davantage) montés en parallèle, dont les résistances sont telles que le courant électrique passe majoritairement par l'élément résistif H1 lors de l'opération de lecture (résistance électrique R1_{TREAD} la plus faible), mais par l'élément résistif H2 lors de l'opération de programmation RESET (résistance électrique R2_{TRESET} la plus faible), permet de tirer parti des propriétés différentes de ces éléments résistifs H1 et H2 lors de ces opérations.

Ainsi, les inventeurs ont constaté que les matériaux susceptibles d'être utilisés comme élément résistif d'une cellule mémoire peuvent présenter une certaine disparité de leurs comportements électriques en température, en termes par exemple de résistivité, mais également de robustesse.

Par robustesse, on entend ici la reproductibilité des propriétés électriques dans l'espace. Ainsi, il est attendu que les mêmes éléments résistifs de différentes cellules mémoires identiques d'un circuit intégré produisent un même échauffement lorsqu'ils sont soumis à un signal électrique de même intensité.

Aussi, l'élément résistif H1 présente des propriétés électriques plus intéressantes que celles de l'élément résistif H2 à la température T_{READ} : il présente en particulier une résistivité plus faible (et donc une résistance électrique plus faible). Aussi, le fait que le courant électrique passe majoritairement par l'élément résistif H1 lors de l'opération de lecture permet notamment de limiter la dégradation des performances de la cellule mémoire lorsqu'elle présente l'état SET. En effet, lors de la lecture de l'état SET, on souhaite mesurer un courant électrique d'intensité élevée dans la mesure où la résistance électrique de la portion active est faible. On ne souhaite donc pas que le courant électrique soit diminué par une résistance électrique importante de l'élément résistif.

En revanche, l'élément résistif H2 présente des propriétés électriques plus intéressantes que celles de l'élément résistif H1 à la température T_{RESET}, par exemple en termes de robustesse. Aussi, le fait que le courant électrique passe majoritairement par l'élément résistif H2 lors de l'opération de programmation RESET permet d'améliorer les performances de la cellule mémoire, mais également celles du circuit intégré qui comporte une matrice de cellules mémoires identiques.

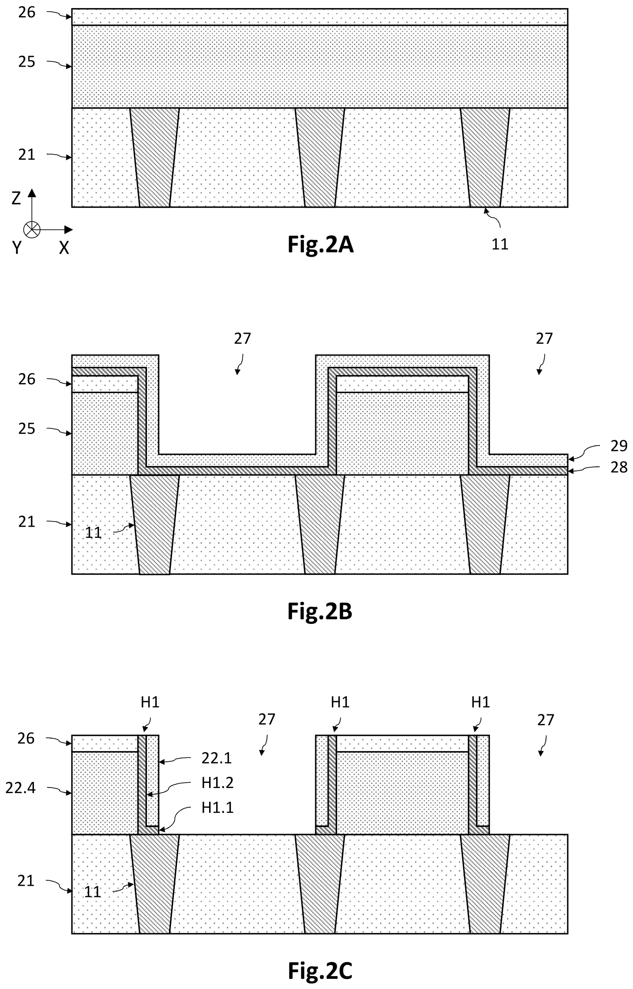

Les **Figures 2A à 2F** illustrent différentes étapes d'un procédé de fabrication d'un circuit intégré 1 comportant une cellule mémoire 10 selon un mode de réalisation, et ici une matrice de cellules mémoires identiques.

En référence à la **Figure 2A****,** on réalise la couche isolante inférieure 21, par exemple en SiO₂, sur une structure FEOL (non représentée). Cette structure FEOL (*Front End Of Line*) comporte des éléments électroniques tels que des transistors à effet de champ.

Des contacts conducteurs inférieurs 11 traversent verticalement la couche isolante inférieure 21. Ils sont réalisés en un matériau électriquement conducteur, par exemple en un ou plusieurs métaux tels que du tungstène.

Une première couche isolante 25, réalisée par exemple en un nitrure de silicium, est déposée de manière à recouvrir la couche isolante inférieure 21 et les contacts conducteurs 11. Son épaisseur correspond sensiblement à la hauteur des éléments résistifs. Une deuxième couche isolante 26, réalisée par exemple en un oxyde de silicium, est déposée sur la première couche isolante 25.

En référence à la **Figure 2B****,** on réalise des ouvertures traversantes 27 au travers de la deuxième couche isolante 26 puis de la première couche isolante 25, pour déboucher sur la couche isolante inférieure 21 et rendre libre une surface supérieure de chaque contact conducteur 11.

Une première couche mince conductrice 28 est ensuite déposée de manière conforme, pour recouvrir continûment la face supérieure de la deuxième couche isolante 26, les flancs de la deuxième couche isolante 26 et de la première couche isolante 25, et la surface libre des contacts conducteurs 11 et de la couche isolante inférieure 21. Cette première couche mince conductrice 28 est destinée à former les premiers éléments résistifs H1. Dans cet exemple, elle est réalisée en TiSiN déposé par CVD. L'épaisseur sur les flancs correspond à l'épaisseur e1 de ce qui sera les éléments résistifs H1.

Une première couche mince de passivation 29 est ensuite déposée de manière conforme pour recouvrir continûment la première couche mince conductrice 28. Cette couche est destinée à former les premiers espaceurs 22.1. Son épaisseur le long des flancs définira l'espacement dans le plan XY entre les éléments résistifs H1 et H2.

En référence à la **Figure 2C****,** on réalise les premiers espaceurs 22.1 et les éléments résistifs H1.

La couche mince de passivation 29 est gravée localement dans les ouvertures 27, ainsi que sur la deuxième couche isolante 26, de manière à former les espaceurs 22.1 qui s'étendent verticalement le long de la couche mince conductrice 28 au niveau des bords des ouvertures 27.

Ensuite, une gravure chimique en voie humide ou par gravure plasma réactive est effectuée, qui supprime le matériau de la couche mince conductrice 28 non protégé par les espaceurs 22.1. On obtient donc des éléments réactifs H1 en architecture 'wall' en forme de L. Les parties inférieures H1.1 des éléments réactifs H1 sont au contact des contacts conducteurs 11, et les parties verticales H1.2 s'étendent verticalement le long des portions 22.4.

Ainsi, la face supérieure de la deuxième couche isolante 26 est rendue libre. De la couche mince conductrice 28, on obtient les éléments résistifs H1, formés chacun d'une partie inférieure H1.1 au contact d'un contact conducteur 11, et d'une partie verticale H1.2. De la couche mince de passivation 29, on ne garde que les portions 22.1 qui recouvrent les parties inférieures H1.1 et s'étendent verticalement le long des parties verticales H1.2. Ces portions 22.1 forment les premiers espaceurs.

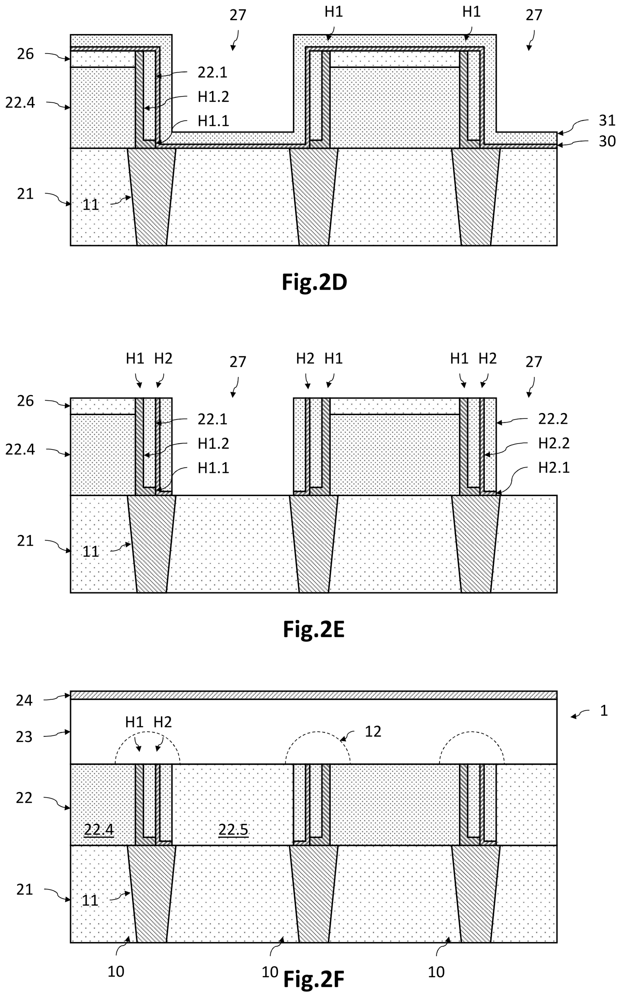

En référence à la **Figure 2D****,** on réitère des étapes similaires à celles des **Figures 2B et 2C** dans le but de réaliser les deuxièmes espaceurs 22.2 et les éléments résistifs H2.

Pour cela, une deuxième couche mince continue conductrice 30 est déposée de manière conforme, de manière à recouvrir continûment la face supérieure de la deuxième couche isolante 26, ainsi que le flanc vertical de l'espaceur 22.1, et enfin la surface libre des contacts conducteurs inférieurs 11 et de la couche isolante inférieure 21. Cette deuxième couche mince conductrice 30 est destinée à former les éléments résistifs H2. Dans cet exemple, elle est réalisée en TiSiN déposé par ALD. L'épaisseur sur les flancs correspond à l'épaisseur e2 de ce qui sera les éléments résistifs H2.

Une deuxième couche mince de passivation 31 est déposée de manière conforme pour recouvrir continûment la deuxième couche mince conductrice 30. Cette couche est destinée à former les deuxièmes espaceurs 22.2.

En référence à la **Figure 2E****,** on réalise les deuxièmes espaceurs 22.2 et les éléments résistifs H2.

La couche de passivation 31 est gravée localement dans les ouvertures 27 ainsi que sur la deuxième couche isolante 26, de manière à former les deuxièmes espaceurs 22.2 qui s'étendent verticalement le long de la couche mince conductrice 30 au niveau des bords des ouvertures 27.

Ensuite, une gravure chimique en voie humide ou par gravure plasma réactive est effectuée, qui supprime le matériau de la couche mince conductrice 30 non protégé par les espaceurs 22.2. On obtient donc des éléments réactifs H2 en architecture 'wall' en forme de L. Les parties inférieures H2.1 des éléments réactifs H2 sont au contact des contacts conducteurs 11, et les parties verticales H2.2 s'étendent verticalement le long des espaceurs 22.1.

Ainsi, la face supérieure de la deuxième couche isolante 26 est à nouveau rendue libre. De la deuxième couche mince conductrice 30, on obtient les éléments résistifs H2, formés chacun d'une partie inférieure H2.1 au contact d'un contact conducteur 11, et d'une partie verticale H2.2 qui s'étend verticalement contre le premier espaceur 22.1. De la deuxième couche mince de passivation 31, on ne garde que les portions 22.2 qui recouvrent les parties inférieures H2.1 et s'étendent verticalement le long des parties verticales H2.1. Ces portions 22.2 forment les deuxièmes espaceurs.

En référence à la **Figure 2F**, on finalise la fabrication des cellules mémoires 10. Pour cela, une couche de remplissage est déposée pour venir remplir les ouvertures, suivi d'une planarisation mécanochimique pour retirer le matériau de remplissage en trop et obtenir ainsi les portions 22.5, et pour retirer la deuxième couche isolante 26 et réduire la hauteur des éléments résistifs H1 et H2, ainsi que celle des espaceurs 22.1, 22.2. On obtient ainsi une face continue plane.

Ensuite, une couche 23 réalisée en le matériau à changement de phase est déposée de manière à recouvrir continûment la couche inférieure intermédiaire 22. Des zones 12 sont au contact électrique et thermique des éléments résistifs H1, H2, qui forment les portions actives des cellules mémoires. Enfin, une couche conductrice 24 est déposée de manière à recouvrir la couche à changement de phase.

Ainsi, on obtient un circuit intégré 1 comportant une matrice de cellules mémoires identiques, chaque cellule mémoire 10 comportant au moins deux éléments résistifs H1, H2 montés en parallèle, dont les résistances électriques présentent les caractéristiques mentionnées précédemment. Ainsi, on obtient des cellules mémoires qui présentent des performances améliorées notamment lors de l'opération de lecture de l'état SET, et lors également de l'opération de programmation RESET.

Des modes de réalisation viennent d'être décrits. Différentes variantes et modifications apparaîtront à l'homme du métier.

## Revendications

1. Cellule mémoire (10), comportant une portion active (12) en un matériau à changement de phase présentant une température de cristallisation (T_{c}) et une température de fusion (T_{f}), comportant :
∘ un premier contact conducteur (11) ;
∘ au moins un premier et un deuxième éléments résistifs (H1, H2), montés électriquement en parallèle, et couplés électriquement au premier contact conducteur (11),
• le premier élément résistif (H1) présentant une résistance électrique (R1) ayant :
- une première valeur (R1_{TREAD}) à une première température (T_{READ}) inférieure à la température de cristallisation (T_{c}), et
- une deuxième valeur (R1_{TRESET}) à une deuxième température (T_{RESET}) supérieure à la température de fusion (T_{f}), inférieure ou égale à sa première valeur (R1_{TREAD}),
• le deuxième élément résistif (H2) présentant une résistance électrique (R2) ayant :
- une première valeur (R2_{TREAD}) à la première température (T_{READ}), supérieure à la première valeur (R1_{TREAD}) du premier élément résistif (H1), et
- une deuxième valeur (R2_{TRESET}) à la deuxième température (T_{RESET}), inférieure à la deuxième valeur (R1_{TRESET}) du premier élément résistif (H1) ;
∘ la portion active (12), couplée aux premier et deuxième éléments résistifs (H1, H2) ;
∘ un deuxième contact conducteur (24), couplé à la portion active (12).

2. Cellule mémoire (10) selon la revendication 1, dans laquelle les premier et deuxième éléments résistifs (H1, H2) comportent chacun une première partie (H1.2, H2.2) s'étendant du premier contact conducteur (11) à la portion active (12), la première partie (H1.2) du premier élément résistif (H1) étant espacée de la première partie (H2.2) du deuxième élément résistif (H2) par un premier espaceur (22.1) réalisé en un matériau électriquement isolant.

3. Cellule mémoire (10) selon la revendication 2, dans laquelle les premier et deuxième éléments résistifs (H1, H2) comportent chacun une deuxième partie (H1.1, H2.1) s'étendant à partir de la première partie (H1.2, H2.2) et située au contact du premier contact conducteur (11), le premier espaceur (22.1) recouvrant la deuxième partie (H1.1) du premier élément résistif (H1).

4. Cellule mémoire (10) selon la revendication 3, comportant un deuxième espaceur (22.2) s'étendant le long d'une surface de la première partie (H2.2) du deuxième élément résistif (H2), opposée au premier espaceur (22.1), et recouvrant la deuxième partie (H2.1) du deuxième élément résistif (H2).

5. Cellule mémoire (10) selon l'une quelconque des revendications précédentes, dans laquelle les premier et deuxième éléments résistifs (H1, H2) présentent des épaisseurs identiques ou différentes.

6. Cellule mémoire (10) selon l'une quelconque des revendications précédentes, dans laquelle, à la première température (T_{READ}), la première valeur (R2_{TREAD}) de la résistance électrique (R2) du deuxième élément résistif (H2) est au moins 2 fois supérieure à la première valeur (R1_{TREAD}) de la résistance électrique (R1) du premier élément résistif (H1).

7. Cellule mémoire (10) selon l'une quelconque des revendications précédentes, dans laquelle le premier élément résistif (H1) et/ou le deuxième élément résistif (H2) sont réalisés en des matériaux à base d'un nitrure de titane silicium et/ou de tungstène.

8. Cellule mémoire (10) selon l'une quelconque des revendications précédentes, dans laquelle la portion active (12) est réalisée en un chalcogénure, de préférence en un composé ternaire de chalcogénure.

9. Circuit intégré (1), comportant une matrice de cellules mémoires (10) identiques selon l'une quelconque des revendications précédentes.

10. Procédé de fabrication d'au moins une cellule mémoire (10) selon l'une quelconque des revendications 1 à 8, comportant les étapes suivantes :
∘ réaliser une première couche isolante (21) et au moins un premier contact conducteur (11) la traversant pour déboucher sur une face supérieure ;
∘ réaliser une deuxième couche isolante (25) recouvrant la première couche isolante (21) et le premier contact conducteur (11) ;
∘ réaliser au moins une ouverture (27) au travers de la deuxième couche isolante (25) et débouchant sur le premier contact conducteur (11) ;
∘ déposer une première couche mince conductrice (28) sur un flanc de l'ouverture (27), et gravure localisée pour obtenir le premier élément résistif (H1) ;
∘ déposer une couche mince isolante (29) sur un flanc du premier élément résistif (H1), et gravure localisée pour obtenir un premier espaceur (22.1) ;
∘ déposer une deuxième couche mince conductrice (30) sur un flanc du premier espaceur (22.1), et gravure localisée pour obtenir le deuxième élément résistif (H2) ;
∘ réalisation de la portion active (12) ;
∘ réalisation du deuxième contact conducteur (24).

11. Procédé de fabrication selon la revendication 10, dans lequel la première couche mince conductrice (28) est déposée par dépôt chimique en phase vapeur.

12. Procédé de fabrication selon la revendication 10 ou 11, dans lequel la deuxième couche mince conductrice (30) est déposée par dépôt par couches atomiques.

13. Procédé de fabrication selon l'une quelconque des revendications 10 à 12, dans lequel la première couche mince conductrice (28) et/ou la deuxième couche mince conductrice (30) sont réalisées en un matériau à base d'un nitrure de titane silicium et/ou de tungstène.

14. Procédé de fabrication selon l'une quelconque des revendications 10 à 12, comportant, avant l'étape de réalisation de la portion active (12), une étape de remplissage de l'ouverture (27), suivie d'une étape de réalisation d'une couche continue (23) en le matériau à changement de phase.

15. Procédé de fabrication d'un circuit intégré (1) comportant une matrice de cellules mémoires (10) identiques réalisées simultanément par le procédé selon l'une quelconque des revendications 10 à 14.
